# EUROPEAN PATENT SPECIFICATION

(11) **EP 2 506 370 B1**
(45) Date of publication and mention of the grant of the patent: **28.10.2015**
(21) Application number: 11160547.3
(22) Date of filing: 30.03.2011
(51) Int. Cl.: H01S 5/02, H01S 5/022, G02B 6/42, H01S 5/042, H01S 5/42

(54) **A submount arrangement for VCSELs**
Subträgeranordnung für VCSELs
Agencement d'embase de récipients

(43) Date of publication of application: 03.10.2012
(73) Proprietor: Huawei Technologies Co., Ltd., Longgang District Shenzhen, Guangdong 518129 (CN)
(72) Inventor: Collins, Tom, 9051 Sint-Denijs-Westrem (BE)
(74) Representative: Körber, Martin Hans

(56) References cited:
- EP-A1- 1 786 043
- EP-A1- 1 914 814
- JP-A- 2007 187 870
- JP-A- 2008 090 218
- US-A- 4 936 808
- US-A1- 2001 031 117
- US-A1- 2005 013 562
- US-A1- 2005 147 360
- US-B1- 7 004 644

## Description

### Field of the Invention

The present invention generally relates to mounting of Vertical-Cavity Surface-Emitting Lasers (VCSELs), a class of semiconductor laser devices that emits light perpendicular to a wafer's surface. More particularly, the invention concerns efficient flip-chip mounting of VCSELs reducing optical coupling losses and enabling passive alignment of the VCSELs.

### Background of the Invention

Individual VCSELs or VCSEL arrays are mounted by direct or indirect attachment of the VCSELs' substrate to another substrate containing a waveguide. The substrate may be glass, silicon, InP, GaAs, etc. VCSELs are typically flip-chip mounted, i.e. the VCSELs are vertically flipped in order to present laser light to a light coupling device, e.g. a planar waveguide, a mirror, an optical detector, a diffraction grating, etc. In most cases, prior to flip-chip, their non-light emitting surface is attached to a substrate (or submount) which is used to facilitate testing and burn-in. Use of such a submount enables easy testing and screening of defect VCSELs prior to flip-chip.

A known way for flip-chip mounting of VCSELs is described in international patent application WO 00/41281 entitled "Method and Apparatus for Hermetically Sealing Photonic Devices". More particularly, Fig. 9-14 and the corresponding sections of the patent application text, i.e. page 9, line 10 to page 11, line 20 of WO 00/41281, describe flip-chip mounting of a VCSEL (901, 1401) using a submount arrangement with substrate (902, 1402), hermetic seal (908, 1408) and cover (1010, 1410) wherein a lens (1008) is integrated. The substrate may or may not be formed with a recess.

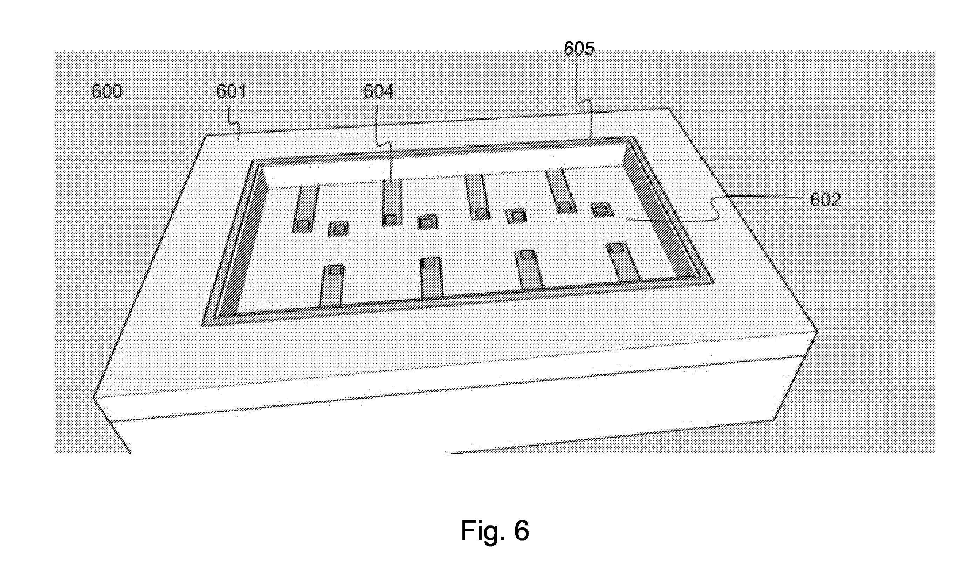

Electrical connectivity is required between the VCSEL and submount. Although not explicitly drawn or shown in Fig. 9-14 of WO 00/41281, such electrical connectivity is traditionally realised through wire bonding, such as for instance illustrated in Fig. 6 of WO 03/058777. This patent application entitled "Submount for vertical Cavity Surface Emitting Lasers and Detectors" shows in Fig. 6 a submount (110) with recess or mounting well (112) wherein a VCSEL (82) is mounted. Bonding wires (80) provide electrical connectivity between the VCSEL and submount, but require locating spacers (114) for spacing any element such as a lens at a relative distance from the VCSEL. This is explicitly acknowledged in paragraph [0032] of WO 03/058777.

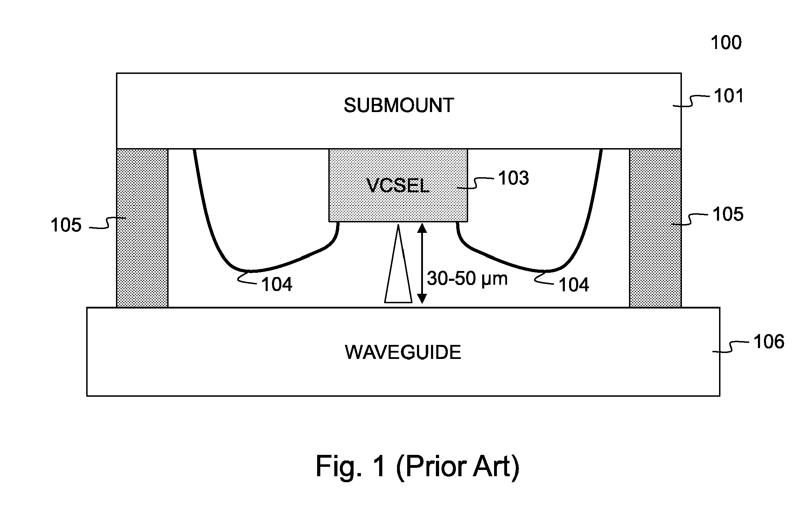

Mounting VCSELs as learned from the individual or combined teaching of WO 00/41281 and WO 03/058777 is disadvantageous for several reasons. Firstly, electrical connectivity between the VCSEL and submount is realised through wire bonding. When the flip-chip is turned upside-down for mounting on a larger waveguide or optical coupling device, the wire bond shall extend at least 30 micrometers from the light emitting surface of the VCSEL. This is illustrated by Fig. 1. As a result, a distance of at least 30 micrometers and usually more than 50 micrometers extending from the light emitting surface of the VCSEL must be kept free. This minimum distance of 30 micrometers to any light coupling device results in high optical coupling losses unless a lens is used. The distance and consequently also the optical coupling losses are even bigger when a flat substrate is used as suggested by Fig. 9-12 of WO 00/41281. Such flat substrate requires spacers that will inevitably increase the distance between VCSEL and light coupling device. To compensate for the optical coupling losses, WO 00/41281 de facto integrates a lens (1008) in the cover of the submount arrangement. Such lenses add cost and introduce additional complexity.

Another drawback resides in the alignment between VCSEL and light coupling device. One option is 'active alignment' where the VCSEL is powered up so that it emits light. As it is aligned over the light coupling device the amount of light actually coupled into the waveguide is measured to find the optimum position. Such active alignment involves measurements, is expensive and time consuming. Passive alignment relies on recognition of alignment marks on the two objects to be aligned and then placing of the objects in the correct position by aligning the sets of marks appropriately. Passive alignment is preferred but requires visual access to alignment marks on the light emitting surface of the VCSEL during flip chip. This is made impossible by WO 00/41281 as the light emitting side of the VCSEL is covered. In other words the lenses that are needed in WO 00/41281 to compensate for the optical losses prevent passive alignment between VCSEL and light coupling device.

United States Patent Application US 2005/0013562 entitled "Optical Component and Manufacture Method of the Same" shows in Fig. 5C a submount arrangement 13 for VCSELs 20. US 2005/0013562 aims at reducing the size and height of such submount arrangements, as is indicated in paragraph [0007] of US 2005/0013562.

The arrangement 13 shown in Fig. 5C of US 2005/0013562 is composed of several ceramic layers 131, wiring 16 between the ceramic layers 131, and a lens 11. Each of the ceramic layers 131 is at least 50 micrometers thick. The lens 11 has the aim to condense the beam emitted by VCSEL 20 and to compensate for the optical losses resulting from the vertical distance the light has to travel.

United States Patent US 7,004,644 entitled "Hermetic Chip-Scale Package for Photonic Devices" describes a submount arrangement with submount 15 having a recess to hold VCSELs 11, 12 that serve to source or detect light to or from an optical fiber 25. The arrangement contains a bumpbonded window 13, and the bumps 16 are further provided with metal traces 28 that have a thickness of less than 5 microns.

Further, EP 1 914 814 A1 refers to a method for producing a radiation-emitting optoelectronic component, a semiconductor chip is mounted by a first main area onto a carrier body and is electrically conductively connected at a first contact area to a first connection region, and a transparent electrically insulating encapsulation layer is applied to the chip and the carrier body. A first cutout in the encapsulation layer for at least partly uncovering a second contact area of the chip is produced, and a second cutout in the encapsulation layer for at least partly uncovering a second connection region of the carrier body is produced. Finally, an electrically conductive layer, which electrically conductively connects the second contact area of the semiconductor chip and the second connection region of the carrier body, is applied.

Further, JP 2008090218 provides in an optical element module, a first region having a liquidphilic property to a material constituting an adhesive is formed at a part of the optical waveguide which transmits light, a second region having the liquidphilic property to the material composing the adhesive is formed also on the surface of an optical element on which the light ray transmitted in the optical waveguide is emitted or made incident, and the optical waveguide and the optical element are fixed by the adhesive formed between the first region and the second region.

Further, US 2005/0147360 A1 refers to a vertical cavity surface emitting laser (VCSEL) module including a substrate provided with an etched region formed on a lower surface thereof, a plurality of layers, for photoproduction, laminated on an upper surface of the substrate, and a VCSEL for emitting the light upwards and downwards, wherein the VCSEL module monitors the output of the VCSEL by detecting the light emitted downwards from the VCSEL.

Further, JP 2007187870 refers to an optical element mounted which transmits or receives an optical signal in the direction perpendicular to a substrate; a cladding layer is formed on the substrate so that the above optical element is embedded therein; a core is formed on the cladding layer; and also a reflecting surface, which propagates the optical signal from the optical element to the core or propagates the optical signal from the core to the optical element, is formed on the core in the location of the above optical element.

Further, US 2001/0031117 A1 refers to optoelectronic packages comprising both an optical array and base chip. The array and base chip are aligned and coupled using a combination of V-grooves, wick stops, and alignment spheres (e.g., precision ball bearings). The array and base chip are passively aligned by disposing an optical fiber having an angled endface onto V-grooves in both the array and base chip. The base chip typically comprises an optical surface device, such as a vertical cavity, surface emitting laser or photodetector.

It is an objective of the present invention to disclose a laser arrangement for VCSELs that overcomes the above mentioned drawbacks of the closest prior art solutions. More particularly, it is an objective of the present invention to disclose a laser arrangement for VCSELs that enables optical coupling losses to be minimised by reducing the distance between VCSEL surface and light coupling device below 30 micrometers. It is a further objective to avoid the use of expensive components like lenses that introduce alignment complexity and prevent passive alignment between VCSEL and light coupling device.

### Summary of the Invention

United States Patent US 4,936,808 entitled "Method and LED Array Head" describes a LED array arrangement. Such LED array arrangements are used for instance in printers and scanners. In such applications, it is key to reduce the horizontal distance between neighbouring LEDs in the LED array in order to increase the density of LEDs per surface unit and accordingly increase the achievable DPI resolution in printers and scanners where the LED arrays are used. Increasing the density of LEDs in LED arrays is also the problem dealt with in US 4,936,808 as indicated in Col. 1, lines 49-58. The solution to increase LED density proposed in US 4,936,808 lies in a simplified wiring between the LED electrodes and a ceramic substrate. This simplified wiring consists of a metal film 34 that interconnects electrode 5 and external wiring 22.

Although US 4,936,808 seems to show some structural resemblance with the submount arrangement according to the invention, US 4,936,808 does not describe VCSEL arrays and does not recognize the problem of vertical distance and optical coupling losses because LED light is not coupled into a light coupling device. The skilled person hence cannot get inspired by US 4,936,808 to solve a problem of vertical distance to light coupling devices and minimizing optical coupling losses between VCSELs and light coupling devices.

Also European Patent Application EP 1 786 043 entitled "Semiconductor Device and Manufacturing Method of Semiconductor Device" describes an arrangement for holding LEDs 102. The arrangement positions the LEDs on bumps 106 and contains rather high support walls that do not enable to position the LEDs at a distance of at most 30 micrometers from a light coupling device. Optical coupling and the losses resulting from the distance to a light coupling device are not relevant for LEDs and it is not suggested in EP 1 786 043 to replace the LEDs with VCSELs and re-dimension the support walls in order to tackle a problem of optical coupling losses there.

The present invention refers to a method for producing a laser arrangement including a submount, said method comprising:
- providing a submount with a recess;
- providing at least one Vertical-Cavity Surface-Emitting Laser or VCSEL in the recess;
- depositing metal connections extending between an upper surface of said at least one VCSEL and an upper surface of said submount, wherein said recess is dimensioned to hold said at least one VCSEL such that said metal connections are substantially flat; and
- providing a planar waveguide light coupling device at a distance of at most 30 micrometers from a light emitting surface of said at least one VCSEL, wherein said step of depositing metal connections comprises a plating technique or a lift-off technique.

In one embodiment, after placing the VCSEL in the submount cavity the cavity or recess is filled, e.g. with a polymer or photoresist, and a metal seed layer is deposited to cover the entire substrate surface. Using photolithography, a particular photoresist pattern is realized covering the entire surface except where the metal connections are needed. The metal connections are electroplated, and thereafter the photoresist is stripped and the thin seed layer is stripped everywhere except where the plated layer is deposited. Following creation of the metal connections the cavity fill material may or may not be removed.

With lift-off, a photoresist is first applied and a patterned region is lithographically defined with a particular vertical or negative resist profile. Metal is then deposited everywhere but will be 'discontinuous' over the resist steps. The photoresist can then be stripped in a wet chemical bath and the metal deposited on top of the resist will be 'lifted off' and removed.

### Brief Description of the Drawings

Fig. 1 illustrates a laser arrangement for mounting VCSEL(s) according to the prior art;
Fig. 2 illustrates a first example of a result covered by the method according to independent claim 1 being a laser arrangement, whereon a flip-chip VCSEL is mounted;
Fig. 3 illustrates a second example of a result covered by the method according to independent claim 1 being a laser arrangement, whereon an array of VCSELs is mounted;
Fig. 4. illustrates a third example of a result covered by the method according to independent claim 1 being a laser arrangement with metal ring enabling hermetic sealing;
Fig. 5 illustrates a example not forming part of the invention with metal ring, slope-walled recess and through-vias;
Fig. 6 illustrates a example of a laser arrangement not forming part of the invention, for backside emitting VCSELs; and
Fig. 7 is a second illustration of the example of Fig. 6 of the submount arrangement, with backside emitting VCSELs.

### Detailed Description of Embodiment(s)

Fig. 1 shows a state of the art VCSEL submount arrangement 100. The VCSEL 103 is mounted onto a flat submount 101. The submount 101 and VCSEL are electrically connected through bonding wires 104. In order to present laser light to a planar waveguide 106 the VCSEL/submount assembly is flipped. The VCSEL 103 and bonding wires 104 require the use of spacers 105 between the waveguide 106 and submount 101. As a result of the bonding wires 104, the light emitting surface of the VCSEL must respect a distance of at least 30 micrometers from the planar waveguide 106. As a consequence, optical coupling losses are high especially for single mode VCSELs.

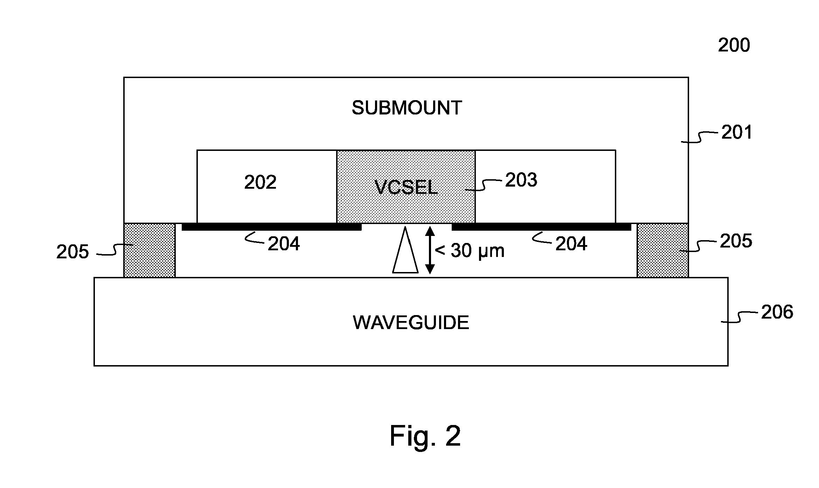

The distance between the light emitting surface of the VCSEL 203 and the waveguide 206 is reduced to at most 30 micrometers in the example result of the present invention of a VCSEL submount arrangement 200 illustrated by Fig. 2. The VCSEL 203 mounted on a submount 201 with recess 202. The electrical connection between VCSEL 203 and submount 201 is realised through substantially flat metal connections 204. These metal connections 204 may be realized through a wafer-level processing technique, e.g. plating or lift-off processing. Thanks to the recess 202 and the substantially flat metal connections 204, the spacers 205 between planar waveguide 206 and and submount 201 can be reduced in height to at most 30 micrometers. As a direct consequence, optical coupling losses between VCSEL 203 and light coupling device 206 are reduced significantly especially for single mode VCSELs.

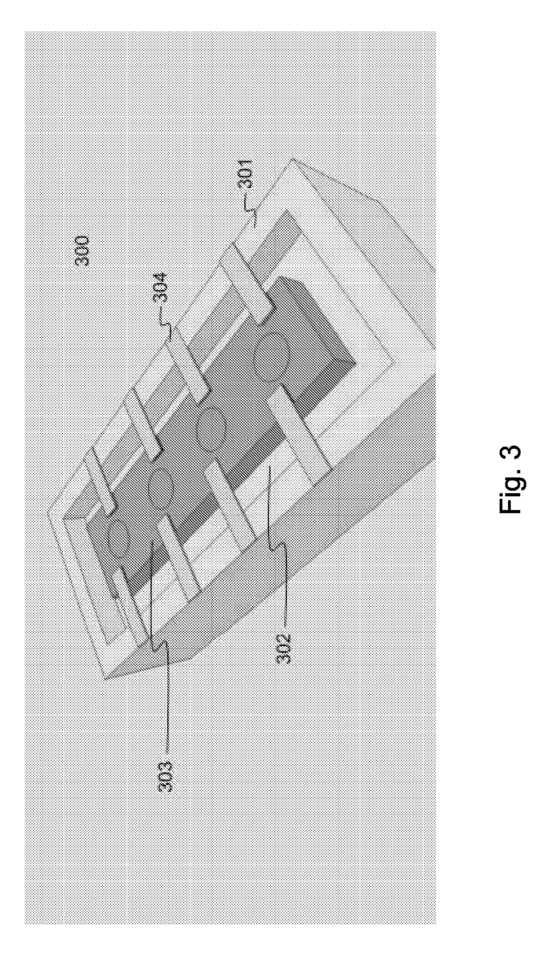

Fig. 3 shows a variant result of the present invention of the submount arrangement 300. The submount 301 in Fig. 3 is dimensioned to hold an array of VCSELs 303 instead of a single VCSEL in recess 302. Substantially flat metal connections 304, similar to the metal connections 204 in the single VCSEL example of Fig. 2, realize electrical connectivity between submount 301 and VCSEL array 303. The recess 302 and flat metal connections 304 allow the light emitting surface of the VCSELs 303 to be presented at close distance of a light coupling device, typically again at a distance below 30 micrometers.

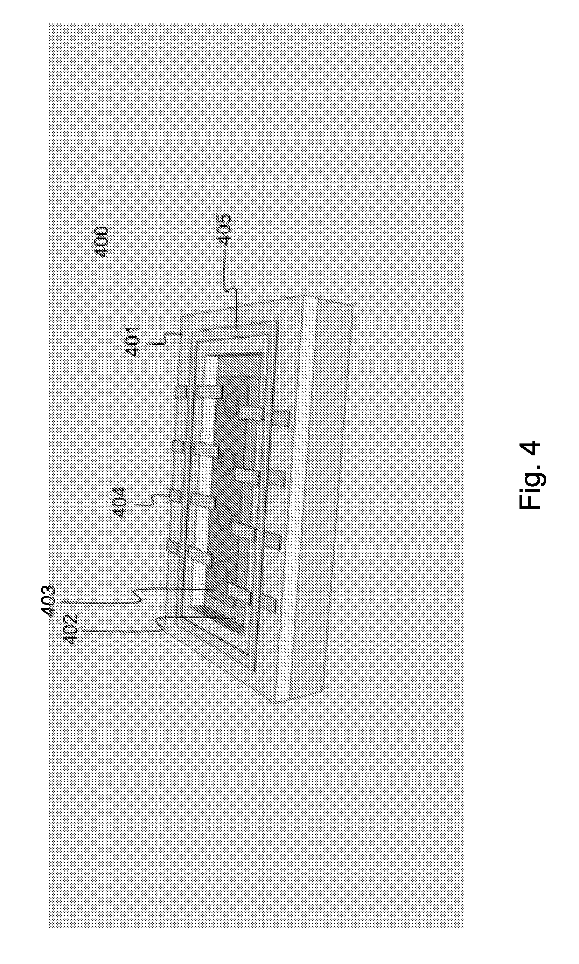

Fig. 4 shows a variant example result of the present invention of the submount arrangement 400, that allows to hermetically seal the cavity formed by the recess 402 and an eventual planar waveguide whereon the submount arrangement 400 is mounted. The hermetic sealing is made possible through a metal ring 405 on the front surface of the submount walls 401. An array of VCSELs 403 is again mounted in a recess 402 of the submount and flat metal connections 404 provide electrical conductivity between the submount walls 401 and the VCSELs 403. These substantially flat metal connections 404 are passing underneath the metal sealing ring 405 separated by an insulating material. This way, the metal connections 404 do not hinder hermetic sealing while they are kept at the front surface of the VCSEL submount. Similarly the sealing ring does not short circuit the different metal connections.

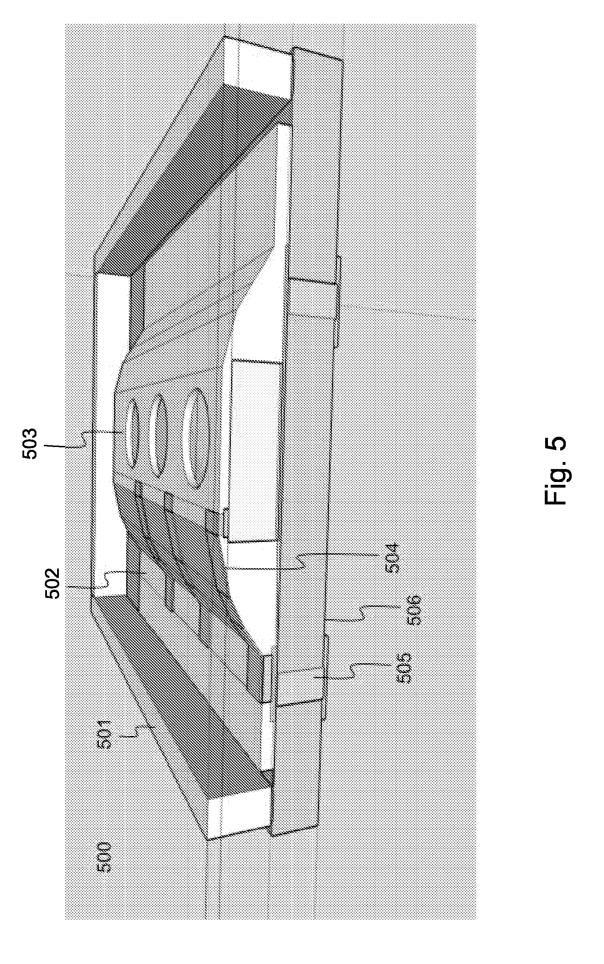

Fig. 5 shows an example not forming part of the invention of the submount arrangement 500 that allows a hermetic seal between the cavity formed by the recess 502 and an eventual substrate containing a planar waveguide whereon the submount arrangement 500 is mounted. In this alternative example , the connections are transferred to the back side of the submount, i.e. the top side in case the submount is flip-chip mounted on a horizontal planar waveguide. The VCSEL array 503 is again positioned in a recess 502 of the submount but the submount is now provided with sloped walls. These sloped walls enable to bring the substantially flat metal connections 504 to a bottom surface of the recess 502. Through-silicon vias 505 extending from the bottom surface of the recess 502 to the back side 506 of the submount enable to transfer the metal connections to the back surface 506. A metal ring provided on the front surface of the submount walls 501 enables hermetic sealing.

Fig. 6 shows yet another example 600 of the submount arrangement not forming part of the invention that is suited for use with backside emitting VCSELs, i.e. VCSELs whose laser light is emitted at the side opposite to the side where the metal connections are provided. The substantially flat metal connections 604 are provided at the bottom surface of the recess 602. Through silicon vias lead the connections to the backside of the submount. A metal ring 605 is provided on top of the submount walls 601 enabling hermetic sealing.

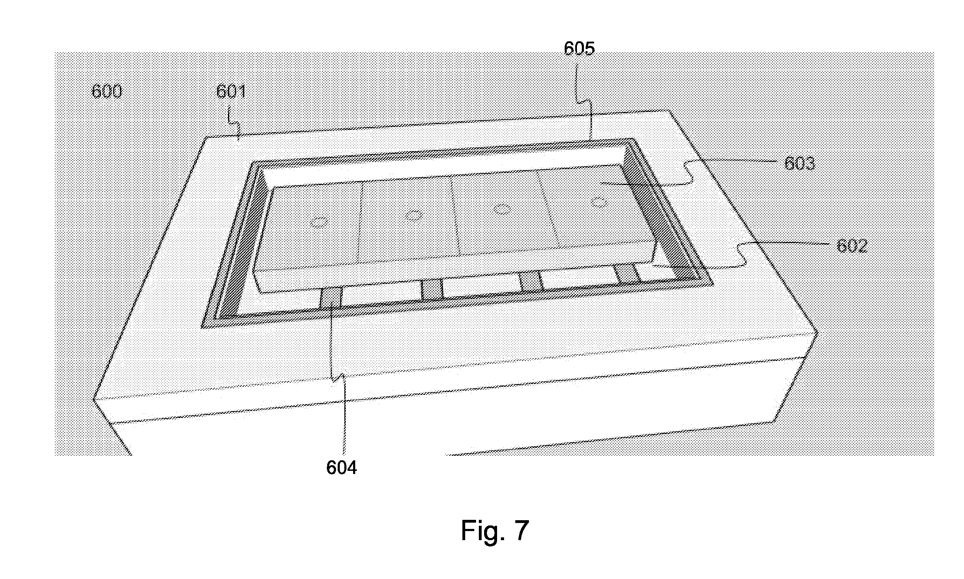

Fig. 7 shows the submount arrangement 600 of Fig. 6 with an array of backside emitting VCSELs 603. These VCSELs are flipped vertically into the cavity 602, their light emitting backside facing upwards.

Although the present invention has been illustrated by reference to specific embodiments, it will be apparent to those skilled in the art that the invention is not limited to the details of the foregoing illustrative embodiments, and that the present invention may be embodied with various changes and modifications without departing from the scope thereof. The present embodiments are therefore to be considered in all respects as illustrative and not restrictive, the scope of the invention being indicated by the appended claims rather than by the foregoing description, and all changes which come within the meaning and range of equivalency of the claims are therefore intended to be embraced therein. In other words, it is contemplated to cover any and all modifications, variations or equivalents that fall within the scope of the basic underlying principles and whose essential attributes are claimed in this patent application. It will furthermore be understood by the reader of this patent application that the words "comprising" or "comprise" do not exclude other elements or steps, that the words "a" or "an" do not exclude a plurality, and that a single element, such as a computer system, a processor, or another integrated unit may fulfil the functions of several means recited in the claims. Any reference signs in the claims shall not be construed as limiting the respective claims concerned. The terms "first", "second", third", "a", "b", "c", and the like, when used in the description or in the claims are introduced to distinguish between similar elements or steps and are not necessarily describing a sequential or chronological order. Similarly, the terms "top", "bottom", "over", "under", and the like are introduced for descriptive purposes and not necessarily to denote relative positions. It is to be understood that the terms so used are interchangeable under appropriate circumstances and embodiments of the invention are capable of operating according to the present invention in other sequences, or in orientations different from the one(s) described or illustrated above.

## Claims

1. A method for producing a laser arrangement (200; 300) including a submount (201, 301), said method comprising:
- providing a submount (201;301) with a recess (202, 302);
- providing at least one Vertical-Cavity Surface-Emitting Laser or VCSEL (203, 303) in the recess (202; 302);
- depositing metal connections (204; 304) extending between an upper surface of said at least one VCSEL (203, 303) and an upper surface of said submount (201; 301), wherein said recess (202; 302) is dimensioned to hold said at least one VCSEL (203; 303) such that said metal connections (204; 304) are substantially flat; and
- providing a planar waveguide light coupling device (206) at a distance of at most 30 micrometers from a light emitting surface of said at least one VCSEL (203,303),
wherein said step of depositing metal connections (204; 304) comprises a plating technique or a lift-off technique.

## Patentansprüche

1. Verfahren zum Herstellen einer Laseranordnung (200; 300) mit einem "Submount" (201, 301), wobei das Verfahren Folgendes umfasst:
- Bereitstellen eines "Submount" (201; 301) mit einer Aussparung (202, 302);
- Bereitstellen mindestens eines oberflächenemittierenden Diodenlasers oder VCSEL (203, 303) in der Aussparung (202; 302);
- Abscheiden von Metallverbindungen (204; 304), die sich zwischen einer oberen Oberfläche des mindestens eines VCSEL (203, 303) und einer oberen Oberfläche des "Submount" (201; 301) erstrecken, wobei die Aussparung (202; 302) so dimensioniert ist, dass sie den mindestens einen VCSEL (203; 303) so hält, dass die Metallverbindungen (204; 304) im Wesentlichen flach sind; und
- Bereitstellen einer Planar-Wellenleiter-Lichtkoppelvorrichtung (206) in einem Abstand von höchstens 30 Mikrometer von einer lichtemittierenden Oberfläche des mindestens einen VCSEL (203, 303),
wobei der Schritt des Abscheidens von Metallverbindungen (204; 304) eine Plattierungstechnik oder eine Abhebtechnik umfasst.

## Revendications

1. Procédé pour produire un agencement laser (200 ; 300) comportant une sous-monture (201, 301), ledit procédé comprenant :
- fournir une sous-monture (201 ; 301) avec un retrait (202, 302) ;
- fournir au moins un laser à émission de surface en cavité verticale ou VCSEL (203, 303) dans le retrait (202 ; 302) ;
- déposer des connexions métalliques (204 ; 304) s'étendant entre une surface supérieure dudit au moins un VCSEL (203, 303) et une surface supérieure de ladite sous-monture (201 ; 301), ledit retrait (202 ; 302) étant dimensionné de manière à retenir ledit au moins un VCSEL (203, 303) de telle sorte que lesdites connexions métalliques (204 ; 304) soient substantiellement plates ; et
- fournir un dispositif de couplage de lumière de guide d'onde plan (206) à une distance ne dépassant pas 30 (im d'une surface émettrice de lumière dudit au moins un VCSEL (203, 303),
ladite étape de dépôt de connexions métalliques (204 ; 304) comprenant une technique de placage ou une technique de lift-off.
